# FASCICULE DE BREVET EUROPEEN

(11) **EP 1 715 518 B1**
(45) Date de publication et mention de la délivrance du brevet: **08.04.2009**
(21) Numéro de dépôt: 06112857.5
(22) Date de dépôt: 20.04.2006
(51) Int. Cl.: H01L 23/00, H05K 1/02

(54) **Dispositif de protection de circuit électronique**
Vorrichtung zum Schutz einer elektrische Schaltung
Device for protecting an electronic circuit

(30) Priorité: 21.04.2005 FR 0551019
(43) Date de publication de la demande: 25.10.2006
(73) Titulaire: ST MICROELECTRONICS S.A., 92120 Montrouge (FR)
(72) Inventeur: Coffy, Romain, 38700 La Tronche (FR)
(74) Mandataire: de Beaumont, Michel

(56) Documents cités:
- US-A- 5 740 527
- US-A- 5 939 784
- US-A- 6 137 693
- US-B1- 6 686 649

## Description

### Domaine de l'invention

La présente invention concerne un dispositif de protection d'un circuit électronique et un procédé de réalisation d'un tel dispositif.

### Exposé de l'art antérieur

De nombreux circuits électroniques, par exemple pour téléphone mobile, sont réalisés en fixant à un support principal, généralement appelé carte mère, des circuits électroniques élémentaires réalisés séparément et remplissant chacun une fonction spécifique. A titre d'exemple, pour un téléphone mobile, un circuit électronique élémentaire correspond à un circuit émetteur/récepteur radio, destiné à être relié à l'antenne du téléphone mobile, et qui effectue la démodulation des signaux reçus au niveau de l'antenne et la modulation des signaux à émettre. Un autre circuit électronique élémentaire correspond à un circuit amplificateur de puissance et permet l'amplification des signaux à émettre fournis par le circuit émetteur/récepteur radio. Chaque circuit électronique élémentaire est réalisé sur un support distinct, par exemple un boîtier à matrice de billes (appelé également boîtier BGA de l'anglais Ball Grid Array) ou un boîtier LGA (de l'anglais Land Grid Array).

Certains circuits électroniques élémentaires peuvent être sensibles aux perturbations électromagnétiques. C'est le cas, par exemple, du circuit émetteur/récepteur radio d'un téléphone mobile qui est généralement fixé à la carte mère, comme le circuit amplificateur de puissance, à proximité de l'antenne. En particulier, le bon fonctionnement du circuit émetteur/récepteur radio peut être gêné par les perturbations électromagnétiques émises par le circuit amplificateur de puissance.

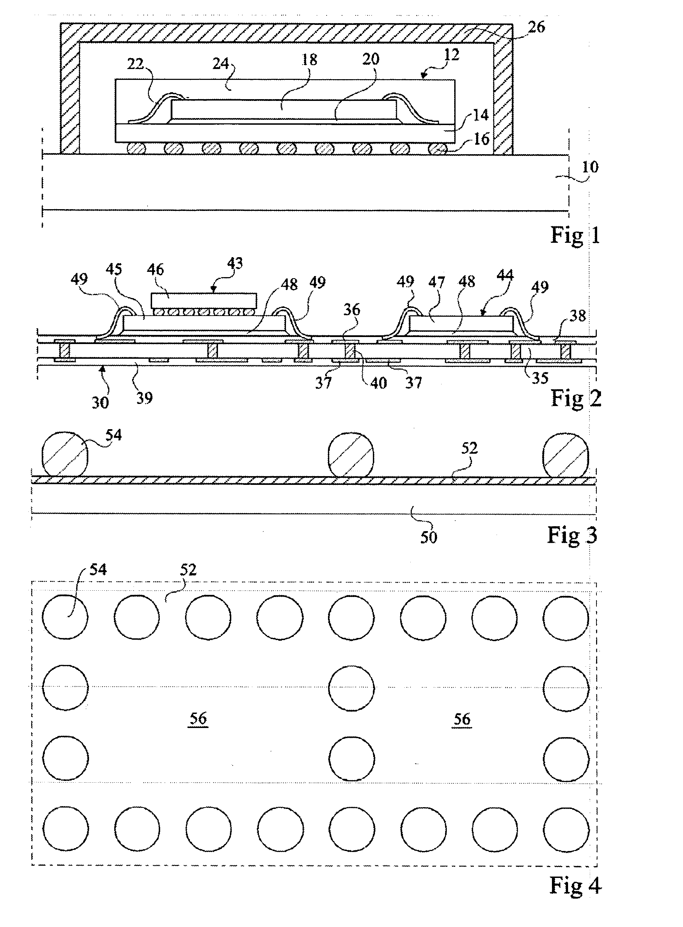

La figure 1 représente un exemple classique de protection d'un circuit électronique élémentaire contre les perturbations électromagnétiques. En figure 1, on a représenté, en coupe, une portion d'une carte mère 10 sur laquelle est soudé un circuit électronique élémentaire 12. A titre d'exemple, le circuit électronique élémentaire 12 est constitué d'un boîtier BGA 14, soudé à la carte mère 10 par l'intermédiaire de billes de soudure 16. Le circuit électronique élémentaire 12 comprend un circuit intégré 18, fixé au boîtier 14 par une couche de colle 20. Des fils électriques 22, par exemple en or, assurent une connexion électrique entre la puce 18 et le boîtier BGA 14. Un bloc de résine 24 recouvre le circuit intégré 18 et le protège contre les chocs mécaniques.

Un autre exemple de protection d'un circuit électronique est divulgué dans le document US-A-6 137 693.

Afin de protéger le circuit intégré 18 contre les perturbations électromagnétiques, on prévoit un couvercle métallique 26, soudé à la carte mère 10 et qui encapsule le circuit 12. Le couvercle 26 est relié à la masse par l'intermédiaire de la carte mère 10. De façon générale, il est nécessaire de prévoir un couvercle métallique, tel que décrit en figure 1, pour chaque circuit électronique élémentaire devant être protégé contre les perturbations électromagnétiques.

Une tendance actuelle est à l'intégration sur un même circuit électronique élémentaire de plusieurs fonctions auparavant réalisées par des circuits élémentaires distincts. A titre d'exemple, en téléphonie mobile, il peut être souhaitable de réaliser un circuit électronique élémentaire unique qui intègre les fonctions auparavant réalisées par le circuit émetteur/récepteur et le circuit amplificateur de puissance. Ceci peut être obtenu en disposant plusieurs circuits intégrés sur un même boîtier BGA ou LGA.

Une difficulté consiste alors à protéger certains constituants d'un tel circuit électronique élémentaire contre les perturbations électromagnétiques émises par d'autres constituants du même circuit électronique élémentaire. En effet, la mise en place de couvercles métalliques directement au niveau du circuit électronique élémentaire est généralement incompatible avec les procédés classiques de fabrication de tels circuits.

### Résumé de l'invention

La présente invention vise à protéger une portion d'un circuit électronique, comprenant au moins un circuit intégré, contre les perturbations électromagnétiques émises par une autre portion, comprenant au moins un autre circuit intégré, du même circuit électronique et contre les perturbations électromagnétiques émises par d'autres circuits électroniques.

Selon un autre objet de la présente invention, le procédé de protection est compatible avec les procédés de fabrication actuels de circuits électroniques.

Selon un autre objet de la présente invention, le procédé de protection modifie peu les étapes d'un procédé de fabrication classique de circuits électroniques.

Pour atteindre ces objets, la présente invention prévoit un dispositif de protection d'un circuit électronique comprenant un support auquel sont fixées au moins deux portions de circuit comportant chacune au moins une puce de circuit intégré. Le dispositif comprend une plaque d'un matériau semiconducteur recouverte d'une couche conductrice disposée parallèlement au support, la plaque étant reliée au support par des piliers conducteurs répartis autour de chaque portion de circuit et en contact avec la couche conductrice.

Selon la présente invention, plusieurs piliers conducteurs adjacents sont espacés, le dispositif comprenant, en outre, une région isolante disposée au moins entre la plaque et le support et recouvrant chaque portion de circuit.

Selon un mode de réalisation de la présente invention, le support comprend une portion plane isolante et des moyens, contenus dans la portion plane, pour connecter des premières pistes conductrices disposées sur une face de la portion plane et des secondes pistes conductrices disposées sur la face opposée, plusieurs piliers conducteurs étant en contact avec des pistes conductrices, parmi les premières pistes conductrices, connectées à des pistes conductrices, parmi les secondes pistes conductrices, destinées à être reliées à une source d'un potentiel de référence.

Selon un mode de réalisation de la présente invention, les piliers conducteurs ont une forme sphérique.

Selon un mode de réalisation de la présente invention, les piliers conducteurs ont une forme au moins en partie cylindrique.

Selon un mode de réalisation de la présente invention, au moins deux piliers conducteurs adjacents sont en contact.

Selon un mode de réalisation de la présente invention, le support est un boîtier à matrice de billes.

La présente invention vise également un procédé de fabrication de circuits électroniques comprenant les étapes suivantes :
(a) prévoir un support plan ;
(b) fixer sur une face du support des portions de circuit contenant chacune au moins une puce de circuit intégré ;
(c) fixer parallèlement à ladite face du support des portions de plaque d'un matériau semiconducteur, chaque portion de plaque recouvrant au moins deux portions de circuit adjacentes, étant couverte d'une couche métallique du côté desdites au moins deux portions de circuit adjacentes et étant reliée au support par des piliers conducteurs répartis autour de chacune desdites au moins deux portions de circuit adjacentes ; et
(d) délimiter des circuits électroniques comportant chacun au moins deux portions de circuit adjacentes et la portion de plaque associée.

Selon un mode de réalisation de la présente invention, au moins plusieurs piliers conducteurs adjacents sont espacés et l'étape (d) est précédée d'une étape consistant à introduire un matériau isolant entre les piliers conducteurs adjacents espacés sous chaque portion de plaque pour recouvrir lesdites au moins deux portions de circuit adjacentes.

Selon un mode de réalisation de la présente invention, les portions de plaque sont obtenues par découpe d'une plaque sur laquelle sont répartis les piliers conducteurs.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente un dispositif classique de protection d'un circuit électronique fixé à un support contre les perturbations électromagnétiques ; et
les figures 2 à 8 illustrent des étapes successives d'un exemple de réalisation de procédé de protection selon l'invention d'un circuit électronique contre les perturbations électromagnétiques.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Les figures 2 à 8 illustrent des étapes successives d'un exemple de réalisation de procédé de fabrication selon l'invention d'un circuit électronique protégé contre les perturbations électromagnétiques.

La figure 2 est une coupe d'un support 30 à partir duquel peuvent être réalisés des boîtiers BGA. Le support 30 a la forme d'une plaque et comprend une couche centrale 35 constituée d'un matériau isolant. Des pistes métalliques 36, 37 sont disposées sur chaque face de la couche centrale 35 et sont recouvertes d'une couche isolante 38, 39. Des vias 40 métalliques sont formés dans la couche centrale 35, chaque via 40 connectant une piste métallique 36 disposée sur une face de la couche centrale 35 à une piste métallique 37 disposée sur la face opposée de la couche centrale 35.

La figure 2 représente la structure obtenue après fixation de circuits électroniques 43, 44 sur le support 30. En figure 2, les deux circuits 43, 44 représentés sont destinés, à la fin du procédé de fabrication, à se trouver sur une même portion du support 30. Toutefois, à la présente étape du procédé de fabrication, les circuits 43, 44 sont reproduits en de nombreux exemplaires sur le support 30. A titre d'exemple, le circuit 43 est un circuit émetteur/récepteur constitué d'une première puce de circuit intégré 45 et d'une seconde puce de circuit intégré 46 fixée à la première puce de circuit intégré 45 selon une liaison de type flip/chip et le circuit 44 est un circuit amplificateur de puissance constitué d'une puce de circuit intégré 47. La fixation des circuits 43, 44 au support 30 est obtenue en déposant des portions de colle 48 sur le support 30, en posant les circuits 43, 44 au niveau des portions de colle 48, et en faisant polymériser les portions de colle 48. Les connexions électriques entre les circuits 43, 44 et le support 30 sont obtenues par l'intermédiaire de fils électriques 49, par exemple en or, connectés à des pistes métalliques 36 au travers de la couche isolante 38. Il est clair que les structures des circuits 43, 44 sont données à simple titre d'illustration, les circuits 43, 44 pouvant comprendre un nombre plus ou moins important de puces de circuit intégré.

Les figures 3 et 4 sont respectivement une coupe et une vue de dessus d'une plaque de silicium polycristallin 50 sur laquelle on a formé une couche métallique 52, par exemple en or, en aluminium ou en argent. A titre d'exemple, l'épaisseur de la plaque 50 est de l'ordre de 150 µm et l'épaisseur de la couche métallique 52 est de l'ordre de 1 à 5 µm. Des billes de soudure 54 (généralement désignées par le terme anglais "bumps"), par exemple en étain, sont réparties sur la couche métallique 52. Les billes de soudure 54 peuvent être réalisées en étalant de la pâte à souder sur la couche métallique 52 à travers un masque pour former des plots de pâte à souder, et en faisant alors fondre les plots de pâte à souder pour leur donner une forme sensiblement sphérique. Pour faciliter le positionnement et la formation des billes de soudure 54, la couche métallique 52 peut être recouverte d'une couche isolante, non représentée, dans laquelle sont formées des ouvertures au niveau des positions souhaitées des billes de soudure 54 pour en faciliter la formation. Selon une variante de réalisation de l'invention, les billes de soudure 54 sont remplacées par les piliers de soudure (généralement désignés par l'expression anglaise "pillar bumps") ayant une forme sensiblement cylindrique, qui peuvent être constitués d'un plot cylindrique en cuivre comportant une extrémité arrondie en étain.

En vue de dessus, les billes de soudure 54 sont réparties sur la plaque 50 selon un quadrillage qui délimite des emplacements 56. A titre d'exemple, les billes de soudure 54 ont un diamètre de l'ordre de 800 µm. Les billes de soudure 54 peuvent être disjointes, la distance séparant deux billes de soudure 54 adjacentes dépendant notamment de la nature des perturbations électromagnétiques dont on souhaite se protéger. Selon une variante de réalisation de la présente invention, les billes de soudure 54 peuvent être jointives. Selon une autre variante de réalisation de la présente invention, certaines billes de soudure 54 adjacentes sont au moins partiellement en contact, tandis que d'autres billes de soudure 54 adjacentes sont disjointes.

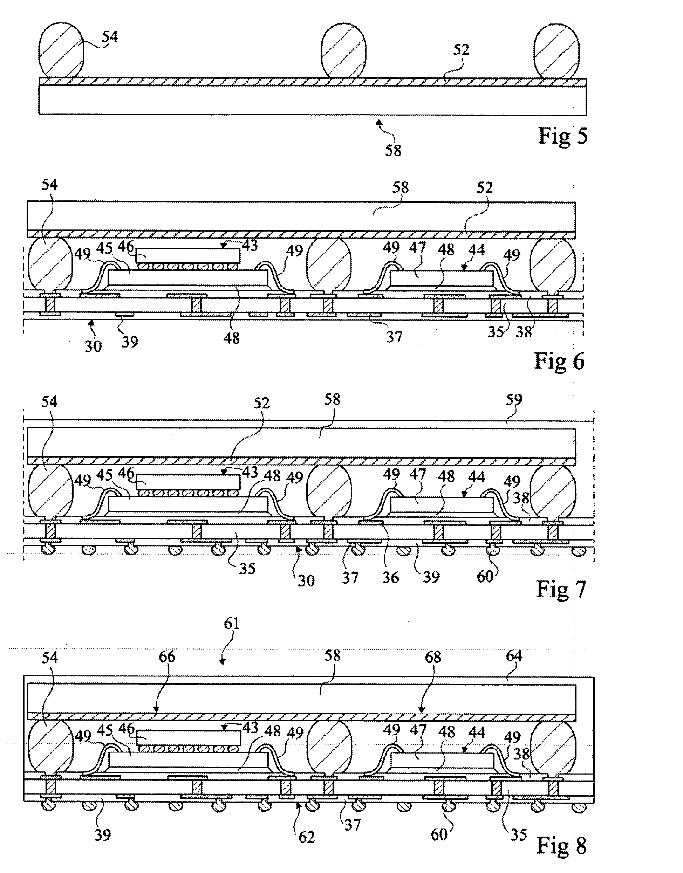

La figure 5 est une coupe de la structure obtenue après avoir découpé la plaque 50 pour former des portions 58 de plaque, une seule portion 58 de plaque étant représentée en figure 5.

La figure 6 est une coupe de la structure obtenue après avoir fixé au support 30 les portions 58 de plaque délimitées à l'étape précédente, seule une portion 58 de plaque étant représentée en figure 5. Chaque portion 58 de plaque peut être fixée au support 30 selon une liaison de type flip-chip en orientant convenablement la portion 58 de plaque de sorte que la couche métallique 52 soit en vis-à-vis du support 30, les circuits 43, 44 se trouvant à l'aplomb des emplacements 56, et en faisant fondre les billes de soudure 54 pour fixer la portion 58 de plaque au support 30. Des ouvertures sont prévues au niveau de la couche isolante 38 pour exposer des pistes métalliques 36 de sorte que, pour chaque portion 58 de plaque, les billes de soudure 54, ou du moins certaines d'entre-elles, sont au contact des pistes métalliques 36 exposées. Chaque circuit 43, 44 est alors entouré de billes de soudure 54 et se trouve à l'aplomb d'une partie de la couche métallique 52.

La figure 7 représente la structure obtenue après la mise en place d'un matériau isolant 59, par exemple une résine époxy et après avoir formé des billes de soudure 60, par exemple en étain, sur la face du support 30 opposée aux circuits 43, 44. Certaines billes de soudure 60 sont connectées à des pistes métalliques 37 du support 30, à travers la couche de résine 39, permettant la réalisation de connexions électriques entre des billes de soudure 60 et des fils électriques 49 et entre des billes de soudure 60 et des billes de soudure 54. Le matériau isolant 59 pénètre sous la portion 58 de plaque et recouvre chaque circuit 43, 44. L'écart entre les billes de soudure 54 et l'écart entre les circuits 43, 44 et la portion 58 de plaque doivent alors être suffisants pour permettre une bonne pénétration de la résine sous la portion 58 de plaque.

La figure 8 représente la structure obtenue après avoir découpé le support 30 et le matériau isolant 59 pour définir des circuits électroniques distincts 61, un seul circuit 61 étant représenté en figure 8. Chaque circuit électronique 61 est constitué, dans le présent exemple, d'une portion 62 du support 30, formant un boîtier BGA, à laquelle sont fixés les circuits 43 et 44, de la portion 58 de plaque recouvrant les circuits 43, 44 et d'un bloc de résine 64 enveloppant la portion 58 de plaque et recouvrant les circuits 43, 44. La découpe des circuits 61 peut être réalisée au moyen d'une scie circulaire dont l'épaisseur peut être de l'ordre de 100 micromètres. Les dimensions de la portion 58 de plaque sont avantageusement inférieures aux dimensions de la portion 62 de support correspondante de façon que la portion 58 de plaque ne soit pas découpée lors de la délimitation des circuits 61.

Selon une variante de la présente invention, l'étape de mise en place du matériau isolant 59 n'est pas présente. Dans ce cas, les billes de soudure 54 peuvent être jointives. Il est alors nécessaire que la portion 58 de plaque ait une épaisseur suffisante, par exemple de l'ordre de 300 µm pour assurer une protection mécanique suffisante des circuits électroniques 43, 44 qu'elle recouvre, protection qui est sinon en partie assurée par le bloc de résine 64. En outre, dans ce cas, la portion 58 de plaque peut venir au contact des circuits 43, 44 ou de l'un d'entre eux.

Le circuit électronique 61 est, par exemple, destiné à être fixé à une carte mère. Les billes de soudure 54 et la couche métallique 52 peuvent alors être mises à la masse par l'intermédiaire des pistes métalliques 36 connectées aux billes de soudure 54, et elles-mêmes connectées à des pistes métalliques 37 reliées à des billes de soudure 60 qui sont, à leur tour, reliées à la masse par l'intermédiaire de la carte mère. Pour chaque circuit 43, 44, l'ensemble formé par les billes de soudure 54 entourant le circuit 43, 44 et la portion de la couche métallique 52 en vis-à-vis du circuit 43, 44 forme une cage métallique 66, 68 qui protège le circuit 43, 44 qu'elle contient contre les perturbations électromagnétiques extérieures, notamment les perturbations électromagnétiques émises par l'autre circuit 43, 44 fixé à la même portion 62 du support 30.

La protection des circuits 43, 44 réalisés sur la même portion 62 du support 30 étant obtenue par les cages métalliques correspondantes 66, 68, il n'est alors plus nécessaire lorsque la portion 62 du support est fixée par la suite à une carte mère de prévoir un couvercle métallique encapsulant la portion 62 de support qui de toute façon ne protégerait pas chaque circuit 43, 44 contre les perturbations électromagnétiques émises par l'autre circuit 43, 44 fixé à la même portion 62 de support. Pour un circuit 61 de dimensions données, la mise en oeuvre du dispositif de protection selon l'invention entraîne un encombrement moins important que celui qui résulte de l'utilisation d'un couvercle métallique. En effet, l'encombrement du dispositif de protection selon la présente invention provient de l'ajout de la portion 58 de plaque dont l'épaisseur est généralement de l'ordre de 150 µm, à laquelle s'ajoute la distance séparant la portion 58 de plaque des circuits 43, 44, présente lorsque de la résine est injectée sous la portion 58 de plaque, et qui est de l'ordre de 150 µm. Lorsqu'un couvercle métallique distinct est utilisé, il est nécessaire de prévoir une région inoccupée au-dessus du circuit 61, généralement supérieure à 1 mm pour permettre la mise en place du couvercle métallique.

De plus, la présente invention permet une mise convenable de la couche métallique 52 et des billes de soudure 54 à la masse de la carte mère. En effet, certaines, voire la totalité des billes de soudure 54 peuvent être directement mises à la masse par l'intermédiaire de pistes conductrices 36, permettant une répartition convenable des potentiels.

La présente invention prévoit un procédé de protection de circuit électronique qui, de façon avantageuse, entraîne peu de modifications par rapport à un procédé classique de fabrication de circuits électroniques. En effet, les étapes de formation des portions de plaque 58 mettent en oeuvre des techniques classiques de procédés de fabrication de circuits électroniques.

Bien entendu, la présente invention est susceptible de diverses variantes et modifications qui apparaîtront à l'homme de l'art. En particulier, la présente invention a été décrite pour la protection de circuits électroniques réalisés sur un même boîtier BGA. Toutefois, la présente invention concerne également la protection de circuits électroniques réalisés sur un même boîtier LGA et, de façon plus générale, la protection de circuits électroniques réalisés sur un même support.

## Revendications

1. Dispositif de protection d'un circuit électronique (61) comprenant un support (62) auquel sont fixées au moins deux portions de circuit (43, 44) comportant chacune au moins une puce de circuit intégré (45, 46, 47), comprenant une plaque (58) d'un matériau semiconducteur recouverte d'une couche conductrice (52) disposée parallèlement au support, la plaque étant reliée au support par des piliers conducteurs (54) répartis autour de chaque portion de circuit et en contact avec la couche conductrice, **caractérisé en ce que** la plaque est constituée d'un matériau semiconducteur et **en ce que** plusieurs piliers conducteurs (54) adjacents sont espacés, le dispositif comprenant, en outre, un matériau isolant (64) disposé au moins entre la plaque (58) et le support (62) et recouvrant chaque portion de circuit (43, 44).

2. Dispositif selon la revendication 1, dans lequel le support (62) comprend une portion plane isolante et des moyens (40), contenus dans la portion plane, pour connecter des premières pistes conductrices (36) disposées sur une face de la portion plane et des secondes pistes conductrices (37) disposées sur la face opposée, plusieurs piliers conducteurs (54) étant en contact avec des pistes conductrices, parmi les premières pistes conductrices, connectées à des pistes conductrices, parmi les secondes pistes conductrices, destinées à être reliées à une source d'un potentiel de référence.

3. Dispositif selon la revendication 1, dans lequel les piliers conducteurs (54) ont une forme sphérique.

4. Dispositif selon la revendication 1, dans lequel les piliers conducteurs (54) ont une forme au moins en partie cylindrique.

5. Dispositif selon la revendication 1, dans lequel au moins deux piliers conducteurs (54) adjacents sont en contact.

6. Dispositif selon la revendication 1, dans lequel le support (62) est un boîtier à matrice de billes.

7. Procédé de fabrication de circuits électroniques (61) comprenant les étapes suivantes :
(a) prévoir un support plan (30) ;
(b) fixer sur une face du support des portions de circuit (43, 44) contenant chacune au moins une puce de circuit intégré ;
(c) fixer parallèlement à ladite face du support des portions (58) de plaque, chaque portion de plaque recouvrant au moins deux portions de circuit adjacentes, étant couverte d'une couche métallique (52) du côté desdites au moins deux portions de circuit adjacentes et étant reliée au support par des piliers conducteurs (54) répartis autour de chacune desdites au moins deux portions de circuit adjacentes ; et
(d) délimiter des circuits électroniques comportant chacun au moins deux portions de circuit adjacentes et la portion de plaque associée,
**caractérisé en ce que** les portions de plaque sont constituées d'un matériau semiconducteur, **en ce qu'**au moins plusieurs piliers conducteurs (54) adjacents sont espacés et **en ce que** l'étape (d) est précédée d'une étape consistant à introduire un matériau isolant (59) entre les piliers conducteurs adjacents espacés sous chaque portion de plaque (58) pour recouvrir lesdites au moins deux portions de circuit (43, 44) adjacentes.

8. Procédé selon la revendication 7, dans lequel les portions de plaque (58) sont obtenues par découpe d'une plaque sur laquelle sont répartis les piliers conducteurs (54).

## Claims

1. A device for protecting an electronic circuit (61) comprising a support (62) to which are attached at least two circuit portions (43, 44), each comprising at least one integrated circuit chip (45, 46, 47), comprising a wafer (58) of a semiconductor material covered with a conductive layer (52) arranged parallel to the support, the wafer being connected to the support by conductive pillars (54) distributed around each circuit portion and in contact with the conductive layer, **characterized in that** the wafer is made of a semiconductive material and several adjacent conductive pillars (54) are spaced apart, the device further comprising an insulating material (64) arranged at least between the wafer (58) and the support (62) and covering each circuit portion (43, 44).

2. The device of claim 1, wherein the support (62) comprises a planar insulating portion and means (40), contained in the planar portion, for connecting first conductive tracks (36) arranged on a surface of the planar portion and second conductive tracks (37) arranged on the opposite surface, several conductive pillars (54) being in contact with conductive tracks, among the first conductive tracks, connected to conductive tracks, among the second conductive tracks, intended to be connected to a source of a reference voltage.

3. The device of claim 1, wherein the conductive pillars (54) have a spherical shape.

4. The device of claim 1, wherein the conductive pillars (54) have an at least partly cylindrical shape.

5. The device of claim 1, wherein at least two adjacent conductive pillars (54) are in contact.

6. The device of claim 1, wherein the support (62) is a ball grid array package.

7. A method for manufacturing electronic circuits (61), comprising the steps of:
(a) providing a planar support (30);
(b) attaching on a surface of the support circuit portions (43, 44), each containing at least one integrated circuit chip;
(c) attaching, parallel to said surface of the support, portions (58) of a wafer, each wafer portion covering at least two adjacent circuit portions, being covered with a metal layer (52) on the side of said at least two adjacent circuit portions and being connected to the support by conductive pillars (54) distributed around each of said at least two adjacent circuit portions; and
(d) delimiting electronic circuits, each comprising at least two adjacent circuit portions and the associated wafer portion, **characterized in that** said plate portions are made of a semiconductor material, at least several adjacent conductive pillars (54) are spaced apart and step (d) is preceded with a step of introducing an insulating material (59) between the spaced apart adjacent conductive pillars under each wafer portion (58) to cover said at least two adjacent circuit portions (43, 44).

8. The method of claim 7, wherein the wafer portions (58) are obtained by sawing of a wafer on which the conductive pillars (54) are distributed.

## Patentansprüche

1. Eine Vorrichtung zum Schützen einer elektronischen Schaltung (61), die einen Träger bzw. eine Halterung (62) aufweist, an dem wenigstens zwei Schaltungsteile (43, 44) befestigt sind, die jeweils wenigstens einen integrierten Schaltungs-Chip (45, 46, 47) aufweisen, einen Wafer (58) aus einem Halbleitermaterial aufweisend, der mit einer leitenden Schicht (52) bedeckt ist, die parallel zu dem Träger angeordnet ist, wobei der Wafer mit dem Träger verbunden ist, durch leitende Säulen bzw. Stützen (54), die um jeden Schaltungsteil herum verteilt sind, und die in Kontakt sind mit der leitenden Schicht, **dadurch gekennzeichnet dass** der Wafer aus einem halbleitenden Material hergestellt ist und mehrere benachbarte leitende Säulen (54) beabstandet sind, wobei die Vorrichtung ferner ein isolierendes Material (64) aufweist, das wenigstens zwischen dem Wafer (58) und dem Träger (62) angeordnet ist, und jeden Schaltungsteil (43, 44) abdeckt.

2. Vorrichtung nach Anspruch 1, wobei der Träger (62) einen ebenen isolierenden Teil und Mittel (40) aufweist, die in dem ebenen Teil enthalten sind und zwar zum Verbinden erster leitender Bahnen (36), die auf einer Oberfläche von dem ebenen Teil angeordnet sind und zweiter leitender Bahnen (37), die auf der entgegengesetzten Oberfläche angeordnet sind, wobei mehrere leitende Säulen (54), die in Kontakt mit leitenden Bahnen von den ersten leitenden Bahnen sind, verbunden sind mit leitenden Bahnen von den zweiten leitenden Bahnen, gedacht sind, um mit einer Quelle von einer Referenzspannung verbunden zu werden.

3. Vorrichtung nach Anspruch 1, wobei die leitenden Säulen (54) eine sphärische Form besitzen.

4. Vorrichtung nach Anspruch 1, wobei die leitenden Säulen (54) eine wenigstens teilweise zylindrische Form besitzen.

5. Vorrichtung nach Anspruch 1, wobei wenigstens zwei benachbarte leitende Säulen (54) in Kontakt stehen.

6. Vorrichtung nach Anspruch 1, wobei der Träger (62) eine Kugelgitteranordnungseinheit bzw. Ball-Grid-Array-Package ist.

7. Ein Verfahren zum Herstellen elektronischer Schaltungen (61), wobei das Verfahren die folgenden Schritte aufweist:
(a) Vorsehen eines ebenen Trägers bzw. einer ebenen Halterung (30);
(b) Befestigen, auf einer Oberfläche von dem Träger, von Schaltungsteilen (43, 44), die jeweils wenigstens einen integrierten Schaltungs-Chip enthalten;
(c) Befestigen, parallel zu der Oberfläche von dem Träger, von Teilen (58) von einem Wafer, wobei jeder Waferteil wenigstens zwei benachbarte Schaltungsteile abdeckt, die abgedeckt sind mit einer Metallschicht (52) auf der Seite von wenigstens zwei benachbarten Schaltungsteilen und die mit dem Träger verbunden sind durch leitende Säulen (54), die um jeden von den wenigstens zwei benachbarten Schaltungsteilen herum verteilt sind; und
(d) Abgrenzen elektronischer Schaltungen, die jeweils wenigstens zwei benachbarte Schaltungsteile und den benachbarten Waferteil aufweisen, **dadurch gekennzeichnet, dass** die ebenen Teile aus einem Halbleitermaterial hergestellt sind, wenigstens mehrere benachbarte leitende Säulen bzw. Stützen (54) beabstandet sind, und vor dem Schritt (d) ein Schritt ist, zum Einführen eines isolierenden Materials (59) zwischen die beabstandeten benachbarten leitenden Säulen unter jedem Waferteil (58) um wenigstens zwei benachbarte Schaltungsteile (43, 44) abzudecken.

8. Verfahren nach Anspruch 7, wobei die Waferteile (58) erlangt werden durch Sägen eines Wafers auf dem die leitenden Säulen (54) verteilt sind.
